(19) Europäisches Patentamt
European Patent Office
Office européen des brevets

(11) **EP 2 434 594 B1**

(12) **EUROPEAN PATENT SPECIFICATION**

(45) Date of publication and mention
of the grant of the patent:
**14.05.2014 Bulletin 2014/20**

(51) Int Cl.:
*G02B 6/12* *(2006.01)*     *H01S 5/026* *(2006.01)*
*H01S 5/0625* *(2006.01)*     *H01S 5/12* *(2006.01)*
*H01S 5/40* *(2006.01)*

(21) Application number: **10290509.8**

(22) Date of filing: **27.09.2010**

(54) **Photonic integrated circuit for wavelength division multiplexing**

Photonische integrierte Schaltung für Wellenlängenmultiplex-Verfahren

Circuit intégré photonique pour multiplexage à division de longueur d'onde

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(43) Date of publication of application:
**28.03.2012 Bulletin 2012/13**

(73) Proprietor: **Alcatel Lucent
75007 Paris (FR)**

(72) Inventors:
 • **Brenot, Romain
  91767 Palaiseau (FR)**
 • **Garreau, Alexandre
  91460 Marcoussis (FR)**

(74) Representative: **Shamsaei Far, Hassan
Alcatel-Lucent International
32, avenue Kléber
92700 Colombes (FR)**

(56) References cited:
**WO-A1-96/37933**     **WO-A2-03/032036**
**US-B1- 6 201 824**

 • **SAHLEN ET AL: "A robust WDM network laser
  source: the DFB cascade laser", CONFERENCE
  ON OPTICAL FIBER COMMUNICATIONS.
  DALLAS, FEB. 16 - 21, 1997; [CONFERENCE ON
  OPTICAL FIBER COMMUNICATIONS], NEW
  YORK, IEEE, US, vol. 6, 1 February 1997
  (1997-02-01), page 235/236, XP002099859, ISBN:
  978-0-7803-3860-9**

**Description**

**FIELD OF INVENTION**

The present document relates to a photonic integrated circuit (PIC) for multiplexing optical signals in a wavelength division multiplexing (WDM) system. In particular, the document relates to a method and system for reducing the size of a PIC for multiplexing optical signals in a WDM system.

**BACKGROUND**

PICs have been developed to reduce packaging costs and the footprint of multi-wavelength emitters. One main market is the metropolitan area network.

PICs are now foreseen for the access network. In the next generation of access networks, wavelength division multiplexing (WDM) will emerge to increase the flexibility of access networks, the number of subscribers and the optical budget (power splitters might be replaced by wavelength demultiplexers, which will also increase the number of possible subscribers).

In fiber-optic communications, WDM is a technology which multiplexes multiple optical carrier signals on a single optical waveguide (e.g. an optical fiber) by using different wavelengths to carry different signals. This allows for a multiplication in capacity, in addition to enabling bidirectional communication over the same optical waveguide. In a WDM system, a multiplexer is used to merge the different optical signals corresponding to different wavelengths together onto the same waveguide, and a demultiplexer is typically used to isolate the different optical signals from the waveguide. When a device does both simultaneously, it can be used as an optical add-drop multiplexer.

US6201824 describes a two-dimensional matrix of complex coupled semiconductor DFB lasers.

WO 96/37933 discloses a serially multiplexed laser wherein different electrodes apply different signals on an electro-optical waveguide.

WO 03/032036 discloses a serially multiplexed laser comprising DFB sources.

The document "A robust WDM network laser source: the DFB cascade laser", by Sahlen et al., Conference on Optical Fiber Communications, Dallas, Feb. 16-21, 1997, pages 235-236, discloses a serially multiplexer DFB laser.

SUMMARY

In access networks, the cost of network components, e.g. the WDM transmitters, is an important issue. As a result, WDM will most likely be coarse (e.g. with a 20 nm wavelength spacing) in order to use uncooled optical emitters. Furthermore, in order to provide a WDM transmitter at low manufacturing cost, it is desirable to achieve a high degree of integration, i.e. it is desirable to provide a WDM transmitter which can transmit light at a high number of different wavelengths on the limited space of a PIC. The present document describes such a WDM transmitter and a corresponding method for implementing such a WDM transmitter.

According to an aspect an optical transmitter or optical emitter is described. In particular, an optical CWDM emitter or transmitter is described. The emitter or transmitter may be integrated on a photonic integrated circuit (PIC). The transmitter may be configured to generate a plurality of optical signals at a corresponding plurality of different wavelengths multiplexed onto an output waveguide. The wavelengths may be in the 1300 nm to 1600 nm range. The spacing between the wavelengths may be about 20 nm or more.

The transmitter may comprise a first and a second converter comprising different first and second active materials configured to emit light at a first and a different second wavelength. The first and second converters may be electro-optical converters configured to convert an electrical signal into an optical signal. In particular, the converter may be configured to convert a modulated electrical signal into a modulated optical signal.

The transmitter may comprise a first converter waveguide traversing or passing through the first and second material of the first and second converter. The second material may be at an output end of the first converter waveguide and the first material may be at an input end (e.g. a rear end of the transmitter), upstream or opposite of the output end, of the first converter waveguide. The output end of the first converter waveguide may be directed towards the output end of the optical transmitter, i.e. towards the output waveguide. In other words, the output end of the first converter waveguide typically leads to the output waveguide.

The second active material may be transparent to the light at the first wavelength. On the other hand, the first active material may be configured to absorb the light at the second wavelength. This may be achieved by selecting appropriate semiconducting materials, e.g. appropriate compositions of Indium (In), Gallium (Ga), Aluminium (Al), Arsenide (As) and/or Phosphorous (P). In particular, this may be achieved if the second wavelength is smaller than the first wavelength,

The converters may be separated by a semitransparent reflector positioned at an output end of the first converter and at an input end of the second converter, the semitransparent reflector being substantially reflective two light at the second wavelength. By doing this, rearward crosstalk between the first and second wavelengths can be reduced. In addition, the semitransparent reflector may be transparent to light at the first wavelength.

The first converter may comprise a first laser using the first active material and the second converter may comprise a second laser using the second active material. The lasers may be distributed feedback lasers (DFB). Such lasers may comprise a grating along the first converter waveguide. Such a grating may comprise a periodic variation of the refractive index of the material of the first converter waveguide, wherein the length of a periodic variation is typically referred to as a grating period or grating pitch $\Lambda$. In particular, the first converter may comprise a first grating at a first grating period, wherein the first grating period is selected based on to the first wavelength, i.e. the first grating period is associated with the first wavelength. In addition, the second converter may comprise a second grating at a second grating period, wherein the second grating period is selected based to the second wavelength, i.e. the second grating period is associated with the second wavelength. The first and second gratings, i.e. their effective refractive indexes $n_{eff}$ and/or their grating periods, are typically configured to have a high reflectivity at the first and second wavelength, respectively. Furthermore, the first and second grating may be configured to be transparent at wavelengths other than the first and second wavelength, respectively.

The transmitter may comprise K groups of N converters $C_{kn}$, k=1,...,K and n=1,...,N with K>1 and N>1. That is to say, in addition to the first and second converter which may be part of a first group of converters, the transmitter may comprise additional groups of converters. K may be greater or equal to 2, 4 and/or 8. K may be smaller or equal to 4, 8, 16 or 32. N may be greater or equal to 2, 3, 4, 8. N may be smaller or equal to 4, 8, 16 or 32. Each group of converters may be configured to generate N optical signals $S_{kn}$ at wavelengths $\lambda_{kn}$, multiplexed onto a corresponding converter waveguide $W_K$. As a result a serially multiplexed optical signal $S_K$ comprising N different wavelengths $\lambda_{kn}$, n=1,...,N, may be obtained at the output end of the converter waveguide $W_K$. That is to say, in addition to the first converter waveguide the transmitter may comprise further converter waveguides $W_k$ for the other additional groups of converters. The converters $C_{kn}$ may comprise different active materials $M_{kn}$ configured to emit light at the wavelength $\lambda_{kn}$, respectively. That is to say, each converter may comprise a different active material configured to emit light at a different wavelength.

As already indicated above, the first and second converter may correspond to the converters $C_{11}$ and $C_{12}$, respectively. Furthermore, the first and second active materials may correspond to the materials $M_{11}$ and $M_{12}$, respectively. In addition, the first converter waveguide may correspond to the converter waveguide $W_1$ traversing the first group of N optical converters $C_{1n}$, n=1,...,N.

In a similar manner to the first converter waveguide, the converter waveguides $W_k$, k=1,...,K, traverse the N active materials $M_{kn}$, n=1,...,N of the k$^{th}$ group of optical converters. In other words, each group of optical converters is traversed by a dedicated converter waveguide $W_k$. Without loss of generality, the indexing of the converters, wavelengths and materials is such that (for all k) material $M_{kN}$ is at an output end of the waveguide $W_k$ and material $M_{k1}$ is at an input end, upstream and/or opposite of the output end, of the waveguide $W_k$.

In order to perform the serial multiplexing along the k$^{th}$ group of converters, the material $M_{ki}$ may be configured to be transparent to and/or to leave unaffected light at a wavelength $\lambda_{kj}$ with j<i. This condition may be met for all i,j=1,...,N. Alternatively or in addition, material $M_{kl}$ may be configured to absorb light at a wavelength $\lambda_{kj}$ with j>i. This condition may be met for all i,j=1,...,N. In other words, the different materials $M_{ki}$ may cause a selective absorption or passage of light, depending on the wavelength $\lambda_{kj}$ of the light. Light at a wavelength $\lambda_{kj}$ with j<i may pass the material $M_{ki}$, while light at a wavelength $\lambda_{kj}$ with j>i may be absorbed by material $M_{ki}$.

The transmitter may comprise an optical combiner configured to multiplex the K serially multiplexed optical signals $S_k$ at the output end of the K converter waveguides $W_k$ onto the output waveguide. This may be done using parallel multiplexing techniques, such as AWG (Arrayed Waveguide Grating) multiplexing or MMI (Multi-Mode Interference) multiplexing.

The K groups of converters $C_{kn}$ may be laterally spaced with respect to one another such that the output end of the K combiner waveguides $W_k$ are at a lateral distance with respect to one another. In other words, the groups of converters may be placed in parallel with respect to their respective combiner waveguides $W_k$. I.e. the combiner waveguides $W_k$ traversing the K groups of converters $C_{kn}$ may be parallel. The combiner may comprise a first merging section, where the lateral distance between the K combiner waveguides $W_k$ is progressively reduced. Furthermore, the combiner may comprise a second merging section, where the light at different wavelengths $\lambda_{kn}$ carried in the combiner waveguides $W_k$, i.e. where the K serially multiplexed optical signals $S_k$, are superimposed within a joint waveguide leading to the output waveguide. The first merging section may comprise a plurality of S-bend waveguides configured to progressively reduce the distance between the K combiner waveguides $W_k$. Preferably, each combiner waveguide $W_k$ is coupled to a corresponding S-bend waveguide.

In order to reduce the crosstalk between wavelengths which are multiplexed onto a joint combiner waveguide $W_k$, the active materials $M_{kn}$ and the corresponding wavelengths $\lambda_{kn}$ may be arranged such that for some or all pairs of neighboring converters $C_{ki}$, $C_{ki+1}$ of the k$^{th}$ group of converters along the combiner waveguide $W_k$, there are K-1 wavelengths of the set of multiplexed wavelengths $\lambda_{kn}$, k=1,...,K and n=1,...,N, which are greater than wavelength $\lambda_{ki+1}$ emitted by converter $C_{ki+1}$ and smaller than wavelength $\lambda_{ki}$ emitted by converter $C_{ki}$. In an embodiment, the active materials $M_{kn}$ and the corresponding wavelengths $\lambda_{kn}$ may be arranged such that $\lambda_{kn} > \lambda_{in}$, for any k>i, and $\lambda_{kn} > \lambda_{ki}$, for any i>n.

As outlined above, the converters $C_{kn}$, k=1,...,K and n=1,...,N may be lasers, in particular DF8 lasers. As such, the converters $C_{kn}$ may comprise corresponding gratings $G_{kn}$, k=1,...,K and n=1,...,N at grating periods

$\lambda_{kn}$, k=1,...,K and n=1,..,N, respectively. The gratings $G_{kn}$ may be implemented as periodic variations of the refractive index of the converter waveguide $W_k$ within the converter $C_{kn}$. That is to say, the grating $G_{kn}$ may be implemented within the converter waveguide $W_k$, and the grating may be different for each converter traversed by the converter waveguide. Alternatively or in addition, the gratings $G_{kn}$ may be implemented in a separate layer parallel to the converter waveguide $W_k$. A grating period $\lambda_{Kn}$ of the grating $G_{kn}$ may be selected such that light at the wavelength $\lambda_{kn}$ is reflected, i.e. the grating period $\Lambda_{kn}$ of the grating $G_{kn}$ may be associated with the wavelength $\lambda_{Kn}$. Furthermore, the grating period $\lambda_{kn}$ of the grating $G_{kn}$ may be selected such that it is transparent to light at other wavelengths than wavelength $\lambda_{kn}$. In particular, the grating period $\Lambda_{kn}$ of the grating $G_{kn}$ may be selected such that it is transparent to light at wavelength $\lambda_{jn}$, for j<k. In an embodiment, the grating period $\Lambda_{kn}$ is selected as

$$\Lambda_{kn} = \frac{1}{2n_{eff}} \lambda_{kn},$$

wherein $n_{eff}$ is the effective index of the grating $G_{kn}$. That is to say, the grating period of a converter may be selected to be proportional to the wavelength emitted by the converter.

According to a further aspect, a method for generating a plurality of optical signals at a corresponding plurality of different wavelengths multiplexed onto an output waveguide is described, The method may comprise the step of providing a first and second converter comprising different first and second active materials configured to emit light at a first and a different second wavelength, In addition, the method may comprise the step of providing a first converter waveguide traversing the first and second material of the first and second converter, the second material being at an output end of the first converter waveguide and the first material being at an input end, upstream of the output end, of the first converter waveguide. The second active material may be transparent to the light at the first wavelength. The output end of the first converter waveguide may lead to the output waveguide.

According to another aspect an optical network, e.g. an optical access network, comprising the optical transmitter or optical emitter described in the present document is described, The optical network may further comprise an optical transmission medium for transmitting the multiplexed optical signal. Furthermore, the optical network may comprise a corresponding optical receiver.

SHORT DESCRIPTION OF THE FIGURES

Some embodiments of apparatus and methods in accordance with embodiments of the present invention are now described, by way of example only, and with reference to the accompanying drawings, in which:

Figure 1 shows a schematic view of an example of an AWG multiplexer and a plurality of electro-optical converters;
Figures 2 and 2a show views of an example of a MMI multiplexer and a plurality of electro-optical converters;
Figure 3 shows a schematic view of an example of a MMI multiplexer and a plurality of groups of electro-optical converters using serial multiplexing;
Figure 4 shows a schematic view of an example of a group of electro-optical converters using serial multiplexing;
Figure 5 shows an example of a MMI multiplexer and a plurality of groups of electro-optical converters using serial multiplexing; and
Figure 6 shows a schematic view of another example of a MMI multiplexer and a plurality of groups of electro-optical converters using serial multiplexing.

DESCRIPTION OF PREFERRED EMBODIMENTS

integrated CWDM emitters which generate light at a plurality of wavelengths (e,g. four wavelengths) may be based on different concepts. The concepts may differ on the way that the light generated by a plurality of CWDM light sources is multiplexed onto a joint optical waveguide.

A first option of multiplexing the light at different wavelength may use an Arrayed Waveguide Grating (AWG) based on silicon on insulator (SOI). An AWG multiplexer is usually built as a PIC, where the light coming from a multitude of input fibers, i.e. a multitude of optical channels, enters a first waveguide section, then propagates through several waveguides of different length and enters a second waveguide section, and is finally coupled into an output fiber. Wavelength multiplexing is based on an interference effect and the different optical path lengths of the waveguides; at least some frequency components of the input fibers propagate through the waveguides, and the output in the output fiber results from the superposition (interference) of these contributions of the at least some frequency components.

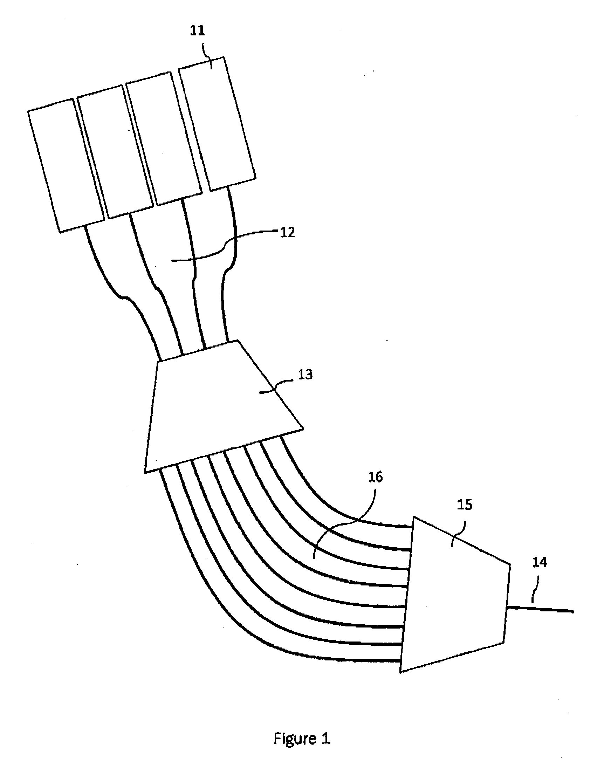

Figure 1 shows an exemplary schematic view of a PIC comprising a plurality of electro-optical converters 11 (e.g. four discrete CWDM lasers) and an AWG multiplexer. The AWG multiplexer may comprise a plurality of waveguides 12, a first multimode section 13, a plurality of arrayed waveguides 16, a second multimode section 16 and an output waveguide 14. The electro-optical converters 11 are configured to convert electronic signals to optical signals, e.g. pulses of light at a specific wavelength. Light from the electro-optical converters 11 propagates through the first plurality of waveguides 12 and enters the first multimode section 13. From the first multimode section 13, the light enters the arrayed waveguides 16. The arrayed waveguides 16 are of different length so that an interference pattern is produced at the second multimode section 16. The plurality of waveguides 12, the first multimode section 13 and the plurality of arrayed waveguides 16 are arranged so that the produced interference pattern focuses the signals into the output waveguide 14 (e.g. a multimode waveguide).

The use of AWG based multiplexers may lead to low multiplexing losses. The AWG based multiplexers can be scaled for a higher number of channels, i.e. for a higher number of different CWDM wavelengths, However, this solution may be very costly as (i) the hybrid integration may require delicate alignment between passive and active waveguides and components; and as (ii) the monolithic integration may lead to large PIC-chip dimensions.

Another option for multiplexing light of a plurality of CWDM lasers is an integrated MMI (multimode interference) device or multiplexer. A MMI multiplexer may be built as a PIC, where the light coming from a plurality of input fibers propagates through a multimode waveguide section into an output waveguide (e.g. an optical fiber). The basis of MMI multiplexers is the self-imaging principle of MMI. That is to say, by selecting the width and length of the multimode waveguide section, self-images of the different wavelengths can be coupled into the output waveguide.

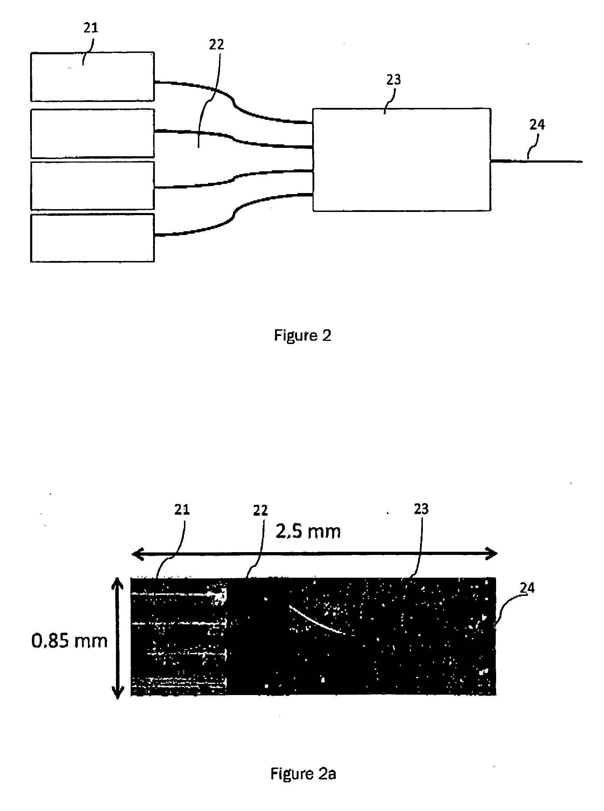

Figures 2 and 2a show schematic exemplary views of an MMI multiplexer in combination with a plurality of electro-optical converters 21 (e.g. four CWDM lasers). The MMI multiplexer may comprise a plurality of waveguides 22, a multimode section 23 and an output waveguide 24. The electro-optical converters 21 are configured to convert electronic signals to optical signals, e.g. pulses of light at specific wavelengths. The electro-optical converters 21 may be distributed feedback (DFB) lasers. The light from the electro-optical converters 21 propagates through the plurality of waveguides 22 and enters the multimode section 23. Typically, the plurality of waveguides 22 corresponds to a plurality of S-bend waveguides. Each mode in the multimode section 23 propagates with a different phase velocity and hence an interference pattern is produced that is dependent on the position along the multimode section 23. By selecting the width and length of the multimode section 23, and the configuration and position of the output waveguide 24 downstream of the multimode section 23, the different wavelengths provided by the plurality of electro-optical converters 21 can be multiplexed into the output waveguide 24.

Preferably, the electro-optical converters 21 are laterally positioned such that the curvature of each waveguide 22 does not exceed a predefined threshold in order to avoid signal losses. In other words, the curvature radius is preferably sufficiently large. In other words, the electro-optical converters 21 are laterally offset and the length of the S-bend waveguide 22 leading from a respective converter 21 to the multimode section 23 may be selected such that the losses due to the S-bends are kept below the predefined threshold.

The PIC comprising four CWDM lasers and an MMI multiplexer to generate four optical channels as depicted in Figs. 2 and 2a may require around 2 mm² per device. That is to say, up to 3500 devices comprising the CWDM lasers and the MMI multiplexer may be manufactured from a 4 inch wafer. The multiplexing losses of the MMI multiplexer are at around 6 dB, which can be compensated with a booster. However, for 8 CWDM channels, i.e. when doubling the number of channels, the size of the device will roughly have to be multiplied by 4 to maintain the same curvature radius of the S-bend waveguides 22. This will reduce the number of PICs which can be manufactured from a 4 inch wafer to less than 1000, thus increasing the cost of the integrated CWDM transmitter, Moreover, the MMI multiplexer losses may be greater than 9 dB, and the passive waveguides of the MMI multiplexer may be much longer. As a consequence, the fabrication yield and the multiplexing losses might become prohibitive when increasing the number of laterally placed DFB lasers (i.e. converters 21).

The above mentioned multiplexing schemes which are based on AWG (Fig. 1) and on MMI (Figs. 2, 2a) will be referred to as parallel multiplexing, as the schemes are directed at multiplexing the light originating from a plurality of parallel (i.e. laterally spaced) electro-optical converters 11, 21. In order to allow for a higher integration of CWDM transmitters, i.e. in order to allow for a higher number of CWDM wavelengths to be generated and multiplexed on the limited space of a PIC, a so called serial multiplexing of wavelengths is described in the following which can be used alternatively or in addition to the parallel multiplexing.

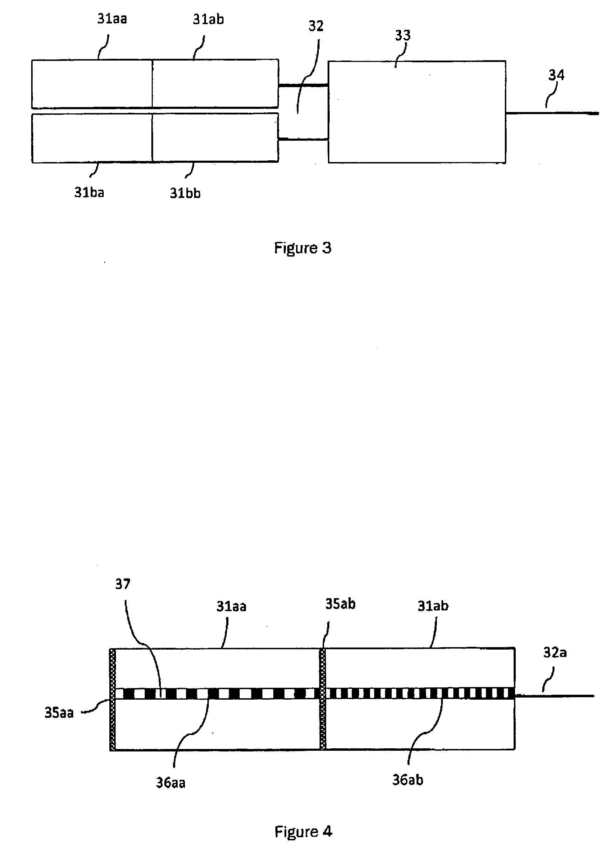

Figure 3 shows a schematic view of an MMI multiplexer using both parallel multiplexing as outlined in the context of Figs, 2 and 2a and serial multiplexing. The converters 21 are replaced by groups of converters 31aa, 31ab and 31ba, 31bb placed in series along the signal path. Fig. 3 illustrates two branches or groups of two converters 31aa, 31ab and 31ba, 31bb which are configured to generate light at different wavelengths. As described with reference to Figure 2, an MMI multiplexer may be used to multiplex the light coming from the plurality of electro-optical converters 31aa, 31ab, 31ba, 31bb. The MMI multiplexer preferably comprises a plurality of (S-bend) waveguides 32, a multimode section 33 and an output waveguide 34. The multimode section 33 may be arranged such that light from the plurality of waveguides 32 is multiplexed into the output waveguide 34, e.g, by using the self-imaging effect as described with reference to Figure 2.

The electro-optical converters 31aa, 31ab, 31ba, 31bb may be light emitting apparatuses. The light emitting apparatuses may be light emitting diodes (LED) or lasers. The lasers may be distributed feedback laser (DFB) lasers. In particular, the lasers may be directly modulated lasers (DML) or lasers using electro-absorption modulation (EAM), i.e. so called Electro-Absorption Modulated Lasers (EML). The material used for such converters 31aa, 31ab, 31ba, 31bb may be semiconductor material, such as Gallium arsenide, indium phosphide, gallium antimonide, and gallium nitride.

Fig. 3 shows an arrangement where serial multiplexing of wavelengths is used in addition to parallel multiplexing based on MMI multiplexing. As a result, a given number of CWDM wavelengths can be multiplexed onto an output waveguide 34 using smaller MMI multiplexers which have tolerable multiplexing losses. The serial multiplexing is achieved by placing in series two or more electro-optical converters 31aa, 31ab. The concept of serial multiplexing is outlined in the context of Fig. 4 which shows an embodiment of the converters 31aa, 31ab of Fig. 3.

The converters 31aa, 31ab comprise different active materials configured to convert an electrical signal into an optical signal. Furthermore, the converters 31aa and 31ab comprise an optical waveguide 37 for confining the emitted optical signal. The optical waveguide 37 traverses the two converters 31aa, 31ab. In particular, the waveguide 37 traverses a first active material of the first converter 31aa and a second active material of the second converter 31ab. By electrically stimulating the first active material, light within a first wavelength interval (referred to as light at a first wavelength) may be emitted. By electrically stimulating the second active material light within a second wavelength interval (referred to as light at a second wavelength) may be emitted. By electrically stimulating both active materials, light signals at the first wavelength and light signals at the second wavelength may be generated simultaneously within the waveguide 37, i.e. the light signals may be serially multiplexed onto the waveguide 37 of the converters 31aa, 31ab. Waveguide 37 may be connected to the waveguide 32a which corresponds to one of the waveguides 32 of the MMI multiplexer depicted In Fig. 3. The waveguide 37 may be a single-mode waveguide, even for the short wavelengths carried by the waveguide 37. In an embodiment, light emitted from the first and second active materials may be light of wavelengths in the wavelength interval of about 1450nm to about 1750 nm. By stimulating the active materials of converters 31aa, 31ab using a modulated electrical signal, modulated optical signals at a first and second wavelength, respectively, may be generated.

By the arrangement illustrated in Figs. 3 and 4, parallel and serial multiplexing of the light generated by the electro-optical converters, e.g. single-wavelengths CWDM emitters, may be used, in order to design multiwavelength CWDM emitters with a large numbers of optical channels, i.e. with a large number of CWDM wavelengths. In particular, this kind of serial multiplexing is feasible in the context of CWDM because of the large wavelength difference between different CWDM channels, which reduces the optical crosstalk between channels which are serially multiplexed.

In view of the fact that the light at the first wavelength traverses the second converter 31ab, the second material used in the second converter 31ab is preferably selected such that light at the first wavelength passes through with low losses. Therefore, appropriate electro-optical materials for the first 31aa and the second 31ab converter may be selected. In an embodiment, the material of the first 31aa and second 31ab converter are selected such that the second wavelength is smaller than the first wavelength. In addition to designing the materials to emit a particular wavelength, the materials may be designed such that light at higher wavelengths than the particular emitted wavelength passes through the electro-optical material unaffected. As such, the second material of the second converter 31ab may be designed to emit the second wavelength and it may be designed to not attenuate light at higher wavelengths than the second wavelength (e.g. light at the first wavelength).

It should be noted that in addition to emitting light at the first wavelength, the material of the first converter 31aa may be selected such that light at the second wavelength, i.e. light at wavelengths which are lower than the first wavelength, is absorbed.

The above conditions regarding the materials may be achieved by selecting appropriate compositions of electro-optical materials such as semiconductor materials comprising Indium (In), Gallium (Ga), Aluminium (Al), Arsenide (As) and/or Phosphorous (P).

The first 31aa and second 31ab converter may comprise a first 36aa and a second 36ab grating, respectively, in order to provide DFB lasers. The first grating 36aa may have a grating period which allows for lasing at the first wavelength. The first 36aa and second 36ab gratings may be implemented as periodic variations of the refractive index of the material of the converter waveguide 37. The periodic variations of the refractive index are illustrated in Fig. 4 by a periodic succession of black and white sections of converter waveguide 37. The first 36aa and second 36ab gratings may have grating periods which allow for lasing at the first and second wavelength, respectively. Furthermore, the second grating 36ab may be transparent to the first wavelength.

In addition, the first 31aa and second 31ab converter may comprise a first 35aa and second 35ab rear reflector, respectively. The rear reflectors 35aa, 35ab may be configured to reflect the light emitted by the respective converter 31aa, 31ab, i.e. the light at the first and second wavelength, respectively. Furthermore, the second rear reflector 35ab, i.e. the rear reflector of the second converter 31ab, may be configured to let pass (a high percentage, e.g. more than 50%, of) the light at the first wavelength. The light at the first and second wavelengths travels downstream towards the waveguide 32a. As such, the backward crosstalk between the different wavelengths can be reduced. Furthermore, the overall efficiency of the lasers can be improved.

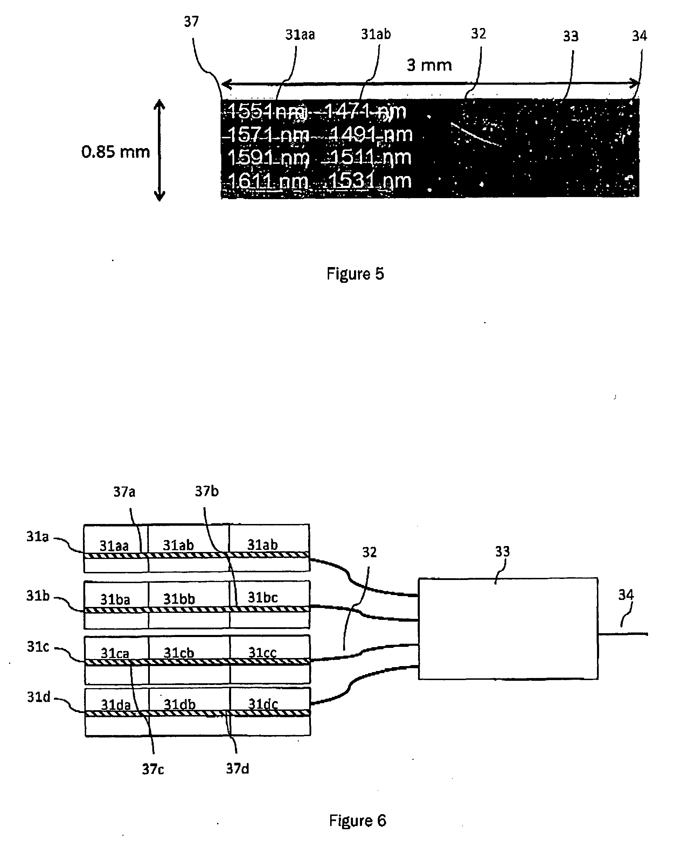

Figure 5 shows an example of a 4-to-1 MMI multiplexer and 4 pairs of serially multiplexed converters 31aa, 31ab. As such, a multi-wavelength CWDM emitter using parallel and serial multiplexing is illustrated. In the CWDM emitter according to Figure 5, 8 CWDM channels are multiplexed and the chip dimensions may be about $0.85*3$ mm$^2$. In the CWDM emitter which uses only the 4-to-1 MMI multiplexer shown in Figure 2a, the dimensions were preferably about $0.85*2.5$ mm$^2$. That means that although the CWDM emitter according to Figure 5 multiplexes 8 channels, i.e. twice the number of channels that are multiplexed by the CWDM emitter shown in Figure 2, the number of devices per wafer may only decrease by 20%. Furthermore, serial multiplexing does not substantially increase the multiplexing losses. As such, the use of serial multiplexing may limit the increase in dimension and multiplexing losses compared to the increase in dimension (typically 400%) and the increase in multiplexing losses which are encountered when using only parallel multiplexing (e.g. when moving from a 4 channel MMI multiplexer to an 8 channel MMI multiplexer).

The different wavelengths generated by the converters 31aa, 31ab may be arranged such that the wavelength difference between serially multiplexed wavelengths is high. This can be achieved by selecting four neighbouring wavelengths (1417nm, 1491nm, 1511nm, 1531nm) for parallel multiplexing and by serially multiplexing the following four wavelengths with the respective other wavelengths (1551nm, 1571nm, 1591nm, 1611nm). This is illustrated in Fig. 5. By attributing the wavelengths to serial and parallel multiplexing in such a manner, the difference between wavelengths which are serially multiplexed can be maximized. In the present example, the CWDM wavelengths are spaced by about 20 nm such that a large channel spacing of about 80 nm between adjacent serially multiplexed emitters can be achieved, thereby reducing the crosstalk.

As outlined above, the material of the different converters is preferably selected appropriately. The material used for emitting light at about 1471 nm (resp. 1491nm, 1511nm and 1531nm), i.e. the material used for the second converter 31ab, may be transparent to the light at about 1551 nm (resp. 1571nm, 1591nm and 1611nm), i.e. to the light emitted in the first converter 31aa. By doing this, the multiplexing losses caused by the serial multiplexing can be reduced. Furthermore, the material used for emitting light at about 1551 nm (resp. 1571nm, 1591nm and 1611nm), i.e. the material used for the first converter 31aa, could completely absorb the emission at about 1471 nm (resp. 1491nm, 1511nm and 1531nm), i.e. the light emitted in the second converter 31ab. By doing this, the backward crosstalk could be reduced. Alternatively or in addition, a negatively biased section, or a reflector as outlined above, may be introduced between the adjacent converters 31aa and 31ab in order to further reduce the backward crosstalk.

It should be noted that while the two electro-optical converters 31aa, 31ab of Figs. 4 and 5 are illustrated for emitting and multiplexing light at two different wavelengths, the underlying principle of serial multiplexing may be extended to an arbitrary number of wavelengths, In general terms, a waveguide W 37 may traverse N serially concatenated converters $C_n$ 31aa, 31ab emitting light at different wavelengths $\lambda_n$, n=1,..., N (N being an arbitrary integer value greater than one), Each wavelength $\lambda n$ belongs to a different wavelength interval $T_n$, n=1, ..., N. Without loss of generality, it is assumed that the different wavelength intervals $T_n$ are ordered according to decreasing wavelengths, i.e. $T_N$ comprises the lowest wavelengths and $T_1$ comprises the highest wavelengths.

In order to emit the different wavelengths $\lambda_n$, the succession of converters $C_n$ 31aa, 31ab comprises different active materials $M_n$, n=1,..., N, i.e. the waveguide W 37 traverses different active materials $M_n$. Each active material $M_n$ may be configured to emit light at a wavelength $\lambda_n$ belonging to the wavelength interval $T_n$, respectively. It is assumed that material $M_N$ is positioned at the output end of the succession of converters $C_n$ and that material $M_1$ is positioned at the input or rear end, opposite or upstream to the output end, of the serially connected converters $C_n$. In other words, material $M_N$ is positioned at the output end of waveguide W 37 and material $M_1$ is positioned at the rear end of waveguide W 37. Each active material $M_i$ is configured to leave unaffected light at a wavelength $\lambda_j$ belonging to the wavelength interval $T_j$, for j<i. In addition, each active material $M_i$ may be configured to absorb light at a wavelength $\lambda_j$ belonging to the wavelength interval $T_j$, for j>i. As such, the light emitted by material $M_i$ passes through materials $M_{i+1},...,M_N$, without being attenuated, in order to reach the output end of the waveguide W 37. Consequently, the serial multiplexing can be performed with low multiplexing losses. On the other hand, the light emitted by material $M_i$ which travels towards the rear end of the waveguide W 37, i.e. which travels towards materials $M_{i-1},...,M_1$ will be absorbed, thereby reducing backward crosstalk.

Optionally, the different regions and materials may be separated by different reflectors $R_n$, n=1,..,N-1, or negatively biased sections, in order to further reduce the crosstalk. The reflectors $R_n$ may be placed at the rear end of a converter $C_n$. Each reflector $R_n$ may be configured to reflect wavelengths $\lambda_n$ from the wavelengths interval $T_n$. Furthermore, each reflector $R_n$ may be configured to let pass wavelengths $\lambda_j$ from the wavelengths interval $T_j$, for j<n. The same or other reflectors may be used for providing converters $C_n$ which comprise laser cavities.

Above a serial connection of converters $C_n$ has been described in more general terms. A plurality of K such serial groups of converters may be placed in parallel, i.e. K such serial connections of converters may be placed in parallel onto a PIC, as shown e.g. in Fig.5. As such, a matrix of converters $C_{kn}$ with n=1,...,N and k=1,...,K, is obtained wherein the converters $C_{kn}$ for a particular value k are connected in series using a com-

mon waveguide $W_k$ 37 as outlined above. The K output signals of the waveguides $W_k$ 37 may be optically multiplexed using parallel multiplexing, e.g. MMI multiplexing or AWG multiplexing. As such a CWDM transmitter or emitter configured to generate and multiplex K*N wavelengths $\lambda_{kn}$, with n=1,...,N and k=1,...,K may be provided. The CWDM transmitter comprises K groups of converters $C_{kn}$, wherein the $k^{th}$ group of converters provides N serially multiplexed optical signals at wavelengths $\lambda_{kn}$, n=1,...,N. As outlined above, the serial multiplexing may be achieved by selecting appropriate active materials $M_{kn}$.

In order to reduce the crosstalk between the serially multiplexed wavelengths $\lambda_{kn}$, the wavelengths may be arranged within the matrix of converters $C_{kn}$ such that for some or all pairs of neighboring converters $C_{ki}$, $C_{kl+1}$ of a group of serial converters along waveguide $W_k$, there are K-1 wavelengths $\lambda_{kn}$ which are greater than wavelength $\lambda_{kl+1}$ emitted by converter $C_{ki+1}$ and smaller than wavelength $\lambda_{kl}$ emitted by converter $C_{kj}$. In an embodiment, this may be achieved by arranging the converter within the matrix such that $\lambda_{kn} > \lambda_{in}$, for k>i, and $\lambda_{kn} > \lambda_{ki}$, for i>n.

Figure 6 shows an exemplary schematic view of an arrangement where three wavelengths are multiplexed in series in four groups 31a, 31b, 31c, 31d of converters prior to performing parallel multiplexing using a 4-to-1 MMI multiplexer. As outlined in the context of Figs. 3 to 5, the MMI multiplexer may comprise a plurality of waveguides 32, a multimode section 33 and an output waveguide 34. The groups 31a, 31b, 31c, 31d of electro-optical converters comprise waveguides 37a, 37b, 37c, 37d which traverse the three converters 31aa-31ac, 31ba-31bc, 31ca-31cc and 31da-31dc, respectively. Each waveguide 37a, 37b, 37c, 37d traverses or passes through three different active materials, i.e. one active material per converter 31aa-31ac, 31ba-31bc, 31ca-31cc and 31da-31dc. As such, each group 31a, 31b, 31c, 31d of converters emits three multiplexed CWDM wavelengths which are subsequently multiplexed using a 4-to-1 MMI multiplexer.

In the present document a method and system of multiplexing light at different wavelengths has been described. In particular, a CWDM transmitter has been described which makes use of serial multiplexing of a plurality of wavelengths. In order to increase the distance between adjacent serially multiplexed wavelengths, and to thereby reduce the crosstalk, serial multiplexing may be combined with parallel multiplexing (e.g. using MMI multiplexers or AWG multiplexers). As a result, low cost and low loss CWDM transmitters may be provided. In particular, CWDM transmitters with a high degree of circuit integration may be provided. Such CWDM transmitters may be implemented as PICs for the use in optical access networks.

It should be noted that the description and drawings merely illustrate the principles of the proposed methods and systems. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the proposed methods and systems and the concepts contributed by the inventors to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Furthermore, it should be noted that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. An optical transmitter configured to generate a plurality of optical signals at a corresponding plurality of different wavelengths multiplexed onto an output waveguide (34); the transmitter comprising:

   - a first (31aa) and second (31ab) converter comprising different first and second active materials configured to emit light at a first and a different second wavelength, respectively; wherein the first active material is configured to absorb the light at the second wavelength and wherein the second wavelength is smaller than the first wavelength; and
   - a first converter waveguide (37a) traversing the first and second material of the first (31aa) and second (31ab) converter, the second material being at an output end of the first converter waveguide (37a) and the first material being at an input end, upstream of the output end, of the first converter waveguide (37); wherein the second active material is transparent to the light at the first wavelength; and wherein the output end of the first converter waveguide (37a) is coupled to the output waveguide (34).

2. The transmitter of any previous claim, wherein the first converter (31aa) comprises a first laser using the first active material and wherein the second converter (31ab) comprises a second laser using the second active material.

**3.** The transmitter of any previous claim, wherein the first converter (31aa) comprises a first grating (36aa) at a first grating period associated with the first wavelength, and wherein the second converter (31ab) comprises a second grating (36ab) at a second grating period associated with the second wavelength.

**4.** The transmitter of any previous claim, further comprising:

- a semitransparent reflector (36ab) positioned at an output end of the first converter (31aa) and at an input end of the second converter (31ab), the semitransparent reflector (36ab) being substantially reflective to light at the second wavelength.

**5.** The transmitter of any previous claim, wherein

- the first and second material are semiconductor materials from a group of materials comprising Gallium, Indium, Aluminium, Phosphorous and/or Arsenide; and
- the transmitter is a photonic integrated circuit.

**6.** The transmitter of any previous claim, wherein the transmitter is an optical coarse wavelength division multiplexing transmitter.

**7.** The transmitter of any previous claim, wherein

- the transmitter comprises K groups (31a, 31b, 31c, 31d) of N converters $C_{kn}$, k=1,...,K and n=1,...,N with K>1 and N>1; each group configured to generate a serially multiplexed optical signal $S_k$ comprising N optical signals at wavelengths $\lambda_{kn}$, n=1,...,N multiplexed onto a converter waveguide $W_k$;
- the converters $C_{kn}$ comprise different active materials $M_{kn}$ configured to emit light at the wavelength $A_{kn}$, respectively;
- the first (31aa) and second (31ab) converter correspond to the converters $C_{11}$ and $C_{12}$, respectively;
- the first and second active materials correspond to the materials $M_{11}$ and $M_{12}$, respectively;
- the first converter waveguide (37a) corresponds to the converter waveguide $W_1$ of the first group of N optical converters $C_{1n}$;
- the converter waveguides $W_k$, k=1,...,K, traverse the N active materials $M_{kn}$, n=1,...,N of the $k^{th}$ group of optical converters; material $M_{kN}$ being at an output end of the waveguide $W_k$ and material $M_{k1}$ being at an input end, upstream of the output end, of the waveguide $W_k$;
- material $M_{ki}$ is configured to be transparent to light at a wavelength $\lambda_{kj}$ with j<i; and

- material $M_{ki}$ is configured to absorb light at a wavelength $\lambda_{kj}$ with j>i; and
- the transmitter comprises an optical combiner (32, 33) configured to multiplex the K serially multiplexed optical signals $S_k$ at the output end of the K converter waveguides $W_k$ onto the output waveguide (34).

**8.** The transmitter of claim 7, wherein

- the converters $C_{kn}$ comprise gratings $G_{kn}$ at grating periods $\Lambda_{kn}$, respectively;
- the first (36aa) and second (36ab) gratings correspond to the gratings $G_{11}$ and $G_{12}$, respectively; and
- the grating periods $\Lambda_{kn}$ are associated with the wavelengths $\lambda_{kn}$ of the light emitted by the corresponding converters $C_{kn}$.

**9.** The transmitter of any of claims 7 to 8, wherein

- the K groups of converters $C_{kn}$ are laterally spaced with respect to one another such that the output end of the K combiner waveguides $W_k$ are at a lateral distance with respect to one another;
- the combiner comprises a first merging section (32), where the lateral distance between the K combiner waveguides $W_k$ is progressively reduced; and
- the combiner comprises a second merging section (33), where the serially multiplexed optical signals $S_k$ are superimposed within a joint waveguide leading to the output waveguide.

**10.** The transmitter of claim 9, wherein the first merging section (32) comprises a plurality of S-bend waveguides configured to progressively reduce the distance between the K combiner waveguides $W_k$.

**11.** The transmitter of any of claims 7 to 10, wherein the combiner (32, 33) is a multimode interference multiplexer.

**12.** The transmitter of any of claims 7 to 11 wherein the active materials $M_{kn}$ and the corresponding wavelengths $\lambda_{kn}$ are arranged such that for at least one pair of neighboring converters $C_{kl}$, $C_{kl+1}$ of the $k^{th}$ group of converters along the combiner waveguide $W_k$, there are K-1 wavelengths of the set of wavelengths $\lambda_{kn}$, k=1,...,K and n=1,...,N, which are greater than wavelength $\lambda_{ki+1}$ emitted by converter $C_{ki+1}$ and smaller than wavelength $\lambda_{ki}$ emitted by converter $C_{ki}$.

**13.** The transmitter of claim 12, wherein the active materials $M_{kn}$ and the corresponding wavelengths $\lambda_{kn}$ are arranged such that $\lambda_{kn} > \lambda_{ln}$, for any k>i, and $\lambda_{kn} > \lambda_{ki}$, for any i>n.

14. A method for generating a plurality of optical signals at a corresponding plurality of different wavelengths multiplexed onto an output waveguide; the method comprising:

   - providing a first (31aa) and second (31ab) converter comprising different first and second active materials configured to emit light at a first and a different second wavelength; wherein the first active material is configured to absorb the light at the second wavelength and wherein the second wavelength is smaller than the first wavelength; and

   - providing a first converter waveguide (37a) traversing the first and second material of the first (31aa) and second (31ab) converter, the second material being at an output end of the first converter waveguide (37a) and the first material being at an input end, upstream of the output end, of the first converter waveguide (37a); wherein the second active material is transparent to the light at the first wavelength; and wherein the output end of the first converter waveguide (37a) is coupled to the output waveguide (34).

**Patentansprüche**

1. Optischer Sender, konfiguriert für die Erzeugung einer Vielzahl von optischen Signalen mit einer entsprechenden Vielzahl von unterschiedlichen Wellenlängen, welche auf einen Ausgangswellenleiter (34) gemultiplext werden; wobei der Sender umfasst:

   - Einen ersten (31aa) und einen zweiten (31ab) Konverter mit unterschiedlichen ersten und zweiten Aktivmaterialien, konfiguriert für das Aussenden von Licht jeweils mit einer ersten und einer unterschiedlichen zweiten Wellenlänge; wobei das erste Aktivmaterial dafür konfiguriert ist, das Licht mit der zweiten Wellenlänge zu absorbieren, und wobei die zweite Wellenlänge kleiner als die erste Wellenlänge ist; und

   - einen ersten Konverter-Wellenleiter (37a), welcher das erste und das zweite Material des ersten (31aa) und des zweiten (31ab) Konverters durchquert, wobei sich das zweite Material an einem Ausgangsende des ersten Konverter-Wellenleiters (37a) und das erste Material an einem Eingangsende, stromaufwärts des Ausgangsendes, des ersten Konverter-Wellenleiters (37) befindet; wobei das zweite Aktivmaterial für das Licht mit der ersten Wellenlänge durchlässig ist, und wobei das Ausgangsende des ersten Konverter-Wellenleiters (37a) an den Ausgangswellenleiter (34) gekoppelt ist.

2. Sender nach Anspruch 1 (of claim 1), wobei der erste Konverter (31aa) einen ersten Laser umfasst, welcher das erste Aktivmaterial benutzt, und wobei der zweite Konverter (31ab) einen zweiten Laser umfasst, welcher das zweite Aktivmaterial benutzt.

3. Sender nach einem beliebigen der vorstehenden Ansprüche, wobei der erste Konverter (31aa) ein erstes Gitter (36aa) mit einer ersten Gitterperiode, welche mit der ersten Wellenlänge assoziiert ist, umfasst, und wobei der zweite Konverter (31 ab) ein zweites Gitter (36ab) mit einer zweiten Gitterperiode, welche mit der zweiten Wellenlänge assoziiert ist, umfasst.

4. Sender nach einem beliebigen der vorstehenden Ansprüche, weiterhin umfassend:

   - Einen halbdurchlässigen Reflektor (36ab), welcher an einem Ausgangsende des ersten Konverters (31aa) und an einem Eingangsende des zweiten Konverters (31ab) angeordnet ist, wobei der halbdurchlässige Reflektor (36ab) im Wesentlichen für Licht mit der zweiten Wellenlänge reflektierend ist.

5. Sender nach einem beliebigen der vorstehenden Ansprüche, wobei

   - Das erste und das zweite Material Halbleitermaterialien aus einer Gruppe, welche Gallium, Indium, Aluminium, Phosphor und/oder Arsenid umfasst, sind; und

   - der Sender eine photonische integrierte Schaltung ist.

6. Sender nach einem beliebigen der vorstehenden Ansprüche, wobei der Sender ein optischer Sender für grobes Wellenlängenmultiplexing ist.

7. Sender nach einem beliebigen der vorstehenden Ansprüche, wobei

   - Der Sender K Gruppen (31a, 31b, 31c, 31d) von N Konvertern $C_{kn}$, k=1,...,K und n=1,...,N mit K>1 und N>1 umfasst; wobei jede Gruppe für die Erzeugung eines seriell gemultiplexten optischen Signals $S_k$, umfassend N optische Signale mit Wellenlängen $\lambda_{kn}$, n=1,...,N, welche auf einen Konverter-Weilenleiter $W_k$ gemultiplext werden, konfiguriert ist;

   - die Konverter $C_{kn}$ unterschiedliche Aktivmaterialien Mkn umfassen, welche jeweils für das Aussenden von Licht mit der Wellenlänge $\lambda_{kn}$ konfiguriert sind;

   - der erste (31 aa) und der zweite (31 ab) Konverter jeweils den Konvertern $C_{11}$ und $C_{12}$ entsprechen;

- das erste und das zweite Aktivmaterial jeweils den Materialien $M_{11}$ und $M_{12}$ entsprechen,
- der erste Konverter-Wellenleiter (37a) dem Konverter-Wellenleiter $W_1$ der ersten Gruppe von N optischen Konvertern $C_{1n}$ entspricht;
- die Konverter-Wellenleiter $W_k$, k=1,...K die N Aktivmaterialien $M_{kn}$, n=1,...,N der k-ten Gruppe von optischen Konvertern durchqueren; wobei sich das Material $M_{kn}$ an einem Ausgangsende des Wellenleiters $W_k$ und das Material $M_{k1}$ an einem Eingangsende, stromaufwärts des Ausgangsendes, des Wellenleiters $W_k$ befindet;
- das Material $M_{ki}$ dafür konfiguriert ist, für Licht mit einer Wellenlänge $\lambda_{kj}$, mit j<i, durchlässig zu sein; und
- das Material $M_{ki}$ dafür konfiguriert ist, Licht mit einer Wellenlänge $\lambda_{kj}$, mit j>i, zu absorbieren; und
- der Sender einen optischen Kombinator (32, 33) umfasst, welcher dafür konfiguriert ist, die K seriell gemultiplexten optischen Signale $S_k$ am Ausgangsende der K Konverter-Wellenleiter $W_k$ auf den Ausgangswellenleiter (34) zu multiplexen.

8. Sender nach Anspruch 7, wobei

- Die Konverter $C_{kn}$ Gitter $G_{kn}$ mit Gitterperioden von jeweils $\Lambda_{kn}$ umfassen;
- das erste (36aa) und das zweite (36ab) Gitter jeweils den Gittern $G_{11}$ und $G_{12}$ entsprechen; und
- die Gitterperioden $\Lambda_{kn}$ mit den Wellenlängen $\Lambda_{kn}$ des von den entsprechenden Konvertern $C_{kn}$ ausgesendeten Lichts assoziiert sind.

9. Sender nach einem beliebigen der Ansprüche 7 bis 8, wobei

- Die K Gruppen von Konvertern $C_{kn}$ in einem seitlichen Abstand voneinander angeordnet sind, so dass sich die Ausgangsenden der K Kombinator-Wellenleiter $W_k$ in einem seitlichen Abstand zueinander befinden;
- der Kombinator einen ersten Zusammenführungsbereich (32) umfasst, wobei sich der seitliche Abstand zwischen den K Kombinator-Wellenleitern $W_k$ zunehmend verringert; und
- der Kombinator einen zweiten Zusammenführungsbereich (33) umfasst, wobei die seriell gemultiplexten optischen Signale $S_k$ innerhalb eines gemeinsamen Wellenleiters, welcher zu dem Ausgangswellenleiter führt, überlagert werden.

10. Sender nach Anspruch 9, wobei der erste Zusammenführungsbereich (32) eine Vielzahl von S-Bogen-Wellenleitern umfasst, welche für das zunehmende Verringern des Abstands zwischen den K Kombinator-Wellenleitern $W_k$ konfiguriert sind.

11. Sender nach einem beliebigen de Ansprüche 7 bis 10, wobei der Kombinator (32, 33) ein Multimode-Interferenzkoppler ist.

12. Sender nach einem beliebigen der Ansprüche 7 bis 11, wobei die Aktivmaterialien $M_{kn}$ und die entsprechenden Wellenlängen $\lambda_{kn}$ derart ausgebildet sind, dass für mindestens ein Paar von benachbarten Konvertern $C_{kl}$, $C_{kl+1}$ der k-ten Gruppe von Konvertern entlang des Kombinator-Wellenleiters $W_k$ K-1 Wellenlängen des Satzes von Wellenlängen $\lambda_{kn}$, k=1,,..,K und n=1,...,N vorhanden sind, welcher größer als die von dem Konverter $C_{ki+1}$ ausgegebene Wellenlänge $\lambda_{ki+1}$ und kleiner als die von dem Konverter $C_{ki}$ ausgegebene Wellenlänge $\lambda_{ki}$ sind.

13. Sender nach Anspruch 12, wobei die Aktivmaterialien $M_{kn}$ und die entsprechenden Wellenlängen $\lambda_{kn}$ derart ausgebildet sind, dass $\lambda_{kn} > \lambda_{in}$ für jeden beliebigen k>i, und $\lambda_{kn} > \lambda_{ki}$ für jeden beliebigen i>n.

14. Verfahren zur Erzeugung einer Vielzahl von optischen Signalen mit einer entsprechenden Vielzahl von unterschiedlichen Wellenlängen, welche auf einen Ausgangswellenleiter gemultiplext werden; wobei das Verfahren umfasst:

- Bereitstellen eines ersten (31aa) und eines zweiten (31ab) Konverters mit unterschiedlichen ersten und zweiten Aktivmaterialien, konfiguriert für das Aussenden von Licht mit einer ersten und einer unterschiedlichen zweiten Wellenlänge; wobei das erste Aktivmaterial dafür konfiguriert ist, das Licht mit der zweiten Wellenlänge zu absorbieren, und wobei die zweite Wellenlänge kleiner als die erste Wellenlänge ist; und
- Bereitstellen eines ersten Konverter-Wellenleiters (37a), welcher das erste und das zweite Material des ersten (31aa) und des zweiten (31 ab) Konverters durchquert, wobei sich das zweite Material an einem Ausgangsende des ersten Konverter-Wellenleiters (37a) und das erste Material an einem Eingangsende, stromaufwärts des Ausgangsendes, des ersten Konverter-Wellenleiters (37a) befindet; wobei das zweite Aktivmaterial für das Licht mit der ersten Wellenlänge durchlässig ist, und wobei das Ausgangsende des ersten Konverter-Wellenteiters (37a) an den Ausgangswellenleiter (34) gekoppelt ist.

**Revendications**

1. Émetteur optique configuré pour générer une pluralité de signaux optiques à une pluralité correspondante de longueurs d'onde différentes multiplexées sur un guide d'ondes de sortie (34) ; l'émetteur comprenant :

   - un premier convertisseur (31aa) et un deuxième convertisseur (31ab) comprenant des premier et deuxième matériaux actifs différents configurés pour émettre de la lumière à une première longueur d'onde et à une deuxième longueur d'onde différente, respectivement ; dans lequel le premier matériau actif est configuré pour absorber la lumière à la deuxième longueur d'onde et dans lequel la deuxième longueur d'onde est inférieure à la première longueur d'onde ; et
   - un premier guide d'ondes convertisseur (37a) traversant le premier et le deuxième matériaux du premier convertisseur (31aa) et du deuxième convertisseur (31 ab), le deuxième matériau étant situé à une extrémité de sortie du premier guide d'ondes convertisseur (37a) et le premier matériau étant situé à une extrémité d'entrée, en amont de l'extrémité de sortie, du premier guide d'ondes convertisseur (37) ; dans lequel le deuxième matériau actif laisse passer la lumière à la première longueur d'onde ; et dans lequel l'extrémité de sortie du premier guide d'ondes convertisseur (37a) est couplée au guide d'ondes de sortie (34).

2. Émetteur selon la revendication 1, dans lequel le premier convertisseur (31aa) comprend un premier laser utilisant le premier matériau actif et dans lequel le deuxième convertisseur (31ab) comprend un deuxième laser utilisant le deuxième matériau actif.

3. Émetteur selon l'une quelconque des revendications précédentes, dans lequel le premier convertisseur (31aa) comprend un premier réseau (36aa) à une première période du réseau associée à la première longueur d'onde, et dans lequel le deuxième convertisseur (31 ab) comprend un deuxième réseau (36ab) à une deuxième période du réseau associée à la deuxième longueur d'onde.

4. Émetteur selon l'une quelconque des revendications précédentes, comprenant en outre :

   - un réflecteur semi-transparent (36ab) positionné à une extrémité de sortie du premier convertisseur (31aa) et à une extrémité d'entrée du deuxième convertisseur (31ab), le réflecteur semi-transparent (36ab) réfléchissant sensiblement la lumière à la deuxième longueur d'onde.

5. Émetteur selon l'une quelconque des revendications précédentes, dans lequel

   - le premier et le deuxième matériaux sont des matériaux semi-conducteurs parmi un groupe de matériaux comprenant le gallium, l'indium, l'aluminium, le phosphore et/ou l'arséniure ; et
   - l'émetteur est un circuit intégré photonique.

6. Émetteur selon l'une quelconque des revendications précédentes, dans lequel l'émetteur est un émetteur optique à multiplexage par répartition approximative en longueur d'onde.

7. Émetteur selon l'une quelconque des revendications précédentes, dans lequel

   - l'émetteur comprend K groupes (31a, 31b, 31c, 31d) de N convertisseurs $C_{kn}$, k=1,...,K et n=1,...,N avec K>1 et N>1 ; chaque groupe étant configuré pour générer un signal optique multiplexé en série $S_k$ comprenant N signaux optiques à des longueurs d'onde $\lambda_{kn}$, n=1...,N multiplexées sur un guide d'ondes convertisseur $W_k$ ;
   - les convertisseurs $C_{kn}$ comprennent des matériaux actifs différents $M_{kn}$ configurés pour émettre de la lumière à la longueur d'onde $\lambda_{kn}$, respectivement ;
   - le premier convertisseur (31aa) et le deuxième convertisseur (31ab) correspondent aux convertisseurs $C_{11}$ et $C_{12}$, respectivement ;
   - les premier et deuxième matériaux actifs correspondent aux matériaux $M_{11}$ et $M_{12}$, respectivement ;
   - le premier guide d'ondes convertisseur (37a) correspond au guide d'ondes convertisseur $W_1$ du premier groupe de N convertisseurs optiques $C_{1n}$,
   - les guides d'ondes convertisseurs $W_k$, k=1,...,K, traversent les N matériaux actifs $M_{kn}$, n=1,...,N du k$^{ème}$ groupe de convertisseurs optiques ;
   - le matériau $M_{kN}$ étant à une extrémité de sortie du guide d'ondes $W_k$ et le matériau $M_{k1}$ étant à une extrémité d'entrée, en amont de l'extrémité de sortie, du guide d'ondes $W_k$ ;
   - le matériau $M_{ki}$ est configuré pour laisser passer la lumière à une longueur d'onde $\lambda_{kj}$ avec j<i ; et
   - le matériau $M_{ki}$ est configuré pour absorber la lumière à une longueur d'onde $\lambda_{kj}$ avec j>i ; et
   - l'émetteur comprend un combineur optique (32, 33) configuré pour multiplexer les K signaux optiques multiplexés en série $S_k$ à l'extrémité de sortie des K guides d'ondes convertisseurs $W_k$ sur le guide d'ondes de sortie (34).

**8.** Émetteur selon la revendication 7, dans lequel

- les convertisseurs $C_{kn}$ comprennent des réseaux $G_{kn}$ à des périodes du réseau $\Lambda_{kn}$, respectivement ;
- le premier réseau (36aa) et le deuxième réseau (31 ab) correspondent aux réseaux $G_{11}$ et $G_{12}$, respectivement ; et
- les périodes du réseau $\Lambda_{kn}$ sont associées aux longueurs d'onde $\lambda_{kn}$ de la lumière émise par les convertisseurs correspondants $C_{kn}$.

**9.** Émetteur selon l'une quelconque des revendications 7 et 8, dans lequel

- les K groupes de convertisseurs $C_{kn}$ sont espacés latéralement les uns par rapport aux autres de sorte que les extrémités de sortie des K guides d'ondes combineurs $W_k$ soient à une distance latérale les unes par rapport aux autres ;
- le combineur comprend une première section de fusion (32), où la distance latérale entre les K guides d'ondes combineurs $W_k$ est progressivement réduite ; et
- le combineur comprend une deuxième section de fusion (33), où les signaux optiques multiplexés en série $S_k$ sont superposés dans un guide d'ondes conjoint s'étendant jusqu'au guide d'ondes de sortie.

**10.** Émetteur selon la revendication 9, dans lequel la première section de fusion (32) comprend une pluralité de guides d'ondes courbés en S configurés pour réduire progressivement la distance entre les K guides d'ondes combineurs $W_k$.

**11.** Émetteur selon l'une quelconque des revendications 7 à 10, dans lequel le combineur (32, 33) est un multiplexeur d'interférence multimode.

**12.** Émetteur selon l'une quelconque des revendications 7 à 11 dans lequel les matériaux actifs $M_{kn}$ et les longueurs d'onde correspondantes $\lambda_{kn}$ sont disposés de sorte que pour au moins une paire de convertisseurs voisins $C_{kl}$, $C_{kl}+1$ du $k^{ème}$ groupe de convertisseurs le long du guide d'ondes combineur $W_k$, il existe K-1 longueurs d'onde de l'ensemble de longueurs d'onde $\lambda_{kn}$, k=1,...,K et n=1,...,N, qui sont supérieures à la longueur d'onde $\lambda_{ki}+1$ émise par le convertisseur $C_{ki}+1$ et inférieures à la longueur d'onde $\lambda_{kl}$ émise par le convertisseur $C_{ki}$.

**13.** Émetteur selon la revendication 12, dans lequel les matériaux actifs $M_{kn}$, et les longueurs d'onde correspondantes $\lambda_{kn}$ sont disposés de sorte que $\lambda_{kn} > \lambda_{ln}$, pour n'importe quel k>i, et $\lambda_{kn} > \lambda_{kl}$, pour n'importe quel i>n.

**14.** Procédé de génération d'une pluralité de signaux optiques à une pluralité correspondante de longueurs d'onde différentes multiplexées sur un guide d'ondes de sortie ; le procédé comprenant les étapes suivantes :

- fournir un premier convertisseur (31aa) et un deuxième convertisseur (31ab) comprenant des premier et deuxième matériaux actifs différents configurés pour émettre de la lumière à une première longueur d'onde et à une deuxième longueur d'onde différente ; dans lequel le premier matériau actif est configuré pour absorber la lumière à la deuxième longueur d'onde et dans lequel la deuxième longueur d'onde est inférieure à la première longueur d'onde ; et
- fournir un premier guide d'ondes convertisseur (37a) traversant le premier et le deuxième matériaux du premier convertisseur (31aa) et du deuxième convertisseur (31ab), le deuxième matériau étant situé à une extrémité de sortie du premier guide d'ondes convertisseur (37a) et le premier matériau étant situé à une extrémité d'entrée, en amont de l'extrémité de sortie, du premier guide d'ondes convertisseur (37) ; dans lequel le deuxième matériau actif laisse passer la lumière à la première longueur d'onde ; et dans lequel l'extrémité de sortie du premier guide d'ondes convertisseur (37a) est couplée au guide d'ondes de sortie (34).

Figure 1

Figure 2

Figure 2a

31aa    31ab        32        33

                                                        34

**Figure 3**

31ba    31bb

37

              31aa        35ab        31ab

                                                        32a

35aa

         36aa              36ab

**Figure 4**

Figure 5

Figure 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6201824 B
- WO 9637933 A
- WO 03032036 A

### Non-patent literature cited in the description

- **SAHLEN et al.** A robust WDM network laser source: the DFB cascade laser. *Conference on Optical Fiber Communications,* 16 February 1997, 235-236